# EUROPEAN PATENT APPLICATION

(11) **EP 4 694 592 A1**
(43) Date of publication of application: **11.02.2026**
(21) Application number: 24803060.3
(22) Date of filing: 09.05.2024
(51) Int. Cl.: H05K 5/06, F25B 30/02

(54) **ELECTRIC CONTROL BOX, OUTDOOR UNIT, AND HEATING AND VENTILATION DEVICE**

(30) Priority: 09.05.2023 CN 202310525053; 24.04.2024 CN 202420871050 U
(71) Applicant: GD Midea Heating & Ventilating Equipment Co., Ltd., Foshan, Guangdong 528311 (CN); Hefei Midea Heating & Ventilating Equipment Co., Ltd., Hefei, Anhui 230088 (CN)
(72) Inventor: WANG, Yingying, Foshan, Guangdong 528311 (CN); LI, Yang, Foshan, Guangdong 528311 (CN); ZHONG, Yonghua, Foshan, Guangdong 528311 (CN); LI, Tengfei, Foshan, Guangdong 528311 (CN); ZHANG, Chengkai, Foshan, Guangdong 528311 (CN)
(74) Representative: Ran, Handong
(86) International application number: PCT/CN2024/091979
(87) International publication number: WO 2024/230781

(57) **Abstract**

An electric control box, an outdoor unit, and a heating and ventilation device. The electric control box (100) comprises an electric control box body (1), an electric control assembly, and a wire outlet sealing member (2); the electric control box body (1) comprises a box main body (12) and a box cover (11) which are connected to each other; the box main body (12) and the box cover (11) are both independently formed members; the electric control assembly is disposed in the electric control box body (1); the wire outlet sealing member (2) is disposed on at least one of the box main body (12) and the box cover (11); wire outlet holes (24) are formed in the wire outlet sealing member (2), and the wire outlet sealing member (2) is an elastomer; and a wire harness assembly (3) electrically connected to the electric control assembly is discharged from the wire outlet holes (24). The wire outlet sealing member (2) is extruded by means of the mutual cooperation between the box main body (12) and the box cover (11), so as to reduce a gap between the wire harness assembly (3) and the inner wall of each wire outlet hole (24).

## Description

### CROSS-REFERENCE TO RELATED APPLICATIONS

This application claims priorities to Chinese Patent Applications No. 202310525053.4, filed on May 9, 2023, and No. 202420871050.6, filed on April 24, 2024, the entire contents of which are incorporated herein by reference.

### FIELD

The present disclosure relates to the technical field of electric control boxes, and in particular, to an electric control box, an outdoor unit, and a heating and ventilation device.

### BACKGROUND

In the related art, a wire harness is connected to an electric control board inside an electric control box. In order to realize normal wire outlet of the wire harness on the electric control board, a wire outlet hole is usually formed on an electric control box body, allowing the wire harness to pass through the wire outlet hole and extend outwards. However, in the related art, there is a gap between the wire harness and the wire outlet hole, resulting in poor sealing performance and causing external dust, liquids, and the like to easily enter the electric control box. When a refrigerant leakage occurs, a refrigerant may enter the electric control box, with great safety hazards.

### SUMMARY

The present disclosure aims to at least solve one of the technical problems existing in the related art. Therefore, an objective of the present disclosure is to provide an electric control box. By providing an elastic wire outlet seal and forming a wire outlet hole in the wire outlet seal, the wire outlet seal is compressed utilizing an acting force from mutual engagement between a main body and a cover. Under the compression, the wire outlet seal may undergo elastic deformation, which can reduce a gap between a wire harness assembly and an inner wall of the wire outlet hole, allow the wire harness assembly to be in an interference fit with the wire outlet hole, and improve sealing performance between the wire harness assembly and the inner wall of the wire outlet hole. In this way, sealing performance of the electric control box is improved, and dust, liquids, or the like, and even a leaked refrigerant can be prevented from entering the electric control box through the gap, which can reduce safety hazards.

The present disclosure further provides an outdoor unit having the electric control box as described above.

The present disclosure further provides a heating and ventilation device having the outdoor unit as described above.

An electric control box according to an embodiment of a first aspect of the present disclosure includes an electric control box body, an electric control assembly and a wire outlet seal. The electric control box body includes a main body and a cover connected to the main body. Each of the main body and the cover is an independently formed part. The electric control assembly is disposed in the electric control box body. The wire outlet seal is disposed on at least one of the main body and the cover. The wire outlet seal has a wire outlet hole and is an elastomer. A wire harness assembly electrically connected to the electric control assembly passes through the wire outlet hole. The wire outlet seal is compressed through mutual engagement between the main body and the cover to reduce a gap between the wire harness assembly and an inner wall of the wire outlet hole.

With the electric control box according to the embodiment of the present disclosure, by providing the elastic wire outlet seal and forming the wire outlet hole in the wire outlet seal, the wire outlet seal is compressed utilizing the acting force from the mutual engagement between the main body and the cover. Under the compression, the wire outlet seal may undergo the elastic deformation, which can reduce the gap between the wire harness assembly and the inner wall of the wire outlet hole, allow the wire harness assembly to be in an interference fit with the wire outlet hole, and improve the sealing performance between the wire harness assembly and the inner wall of the wire outlet hole. In this way, the sealing performance of the electric control box is improved, and the dust, liquids, or the like, and even the leaked refrigerant can be prevented from entering the electric control box through the gap, which can reduce the safety hazards.

According to some embodiments of the present disclosure, the wire outlet seal is a rubber part.

According to some embodiments of the present disclosure, the wire outlet seal is integrally formed on the cover or the main body; or the wire outlet seal is bonded to the at least one of the main body and the cover; or the wire outlet seal is detachably connected to the at least one of the main body and the cover.

According to some embodiments of the present disclosure, the wire harness assembly includes a wire bundling member and an electric control wire harness. The wire bundling member is configured to fix the electric control wire harness and located at the wire outlet hole. The wire outlet seal is compressed through the mutual engagement between the main body and the cover to seal the gap between the wire bundling member and the inner wall of the wire outlet hole.

According to some optional embodiments of the present disclosure, the wire bundling member is integrally injection-molded with the electric control wire harness.

According to some optional embodiments of the present disclosure, at least one wire harness assembly is provided, and the electric control wire harness of the at least one wire harness assembly includes a plurality of wire bodies.

According to some optional embodiments of the present disclosure, at least one wire harness assembly is provided. The at least one wire harness assembly includes two separately routed electric control wire harnesses connected to components with different powers.

According to some embodiments of the present disclosure, the at least one of the main body and the cover has a wire outlet notch. The wire outlet seal includes a wire outlet portion. The wire outlet hole is formed on the wire outlet portion. The wire outlet portion is at least partially located at the wire outlet notch.

According to some optional embodiments of the present disclosure, the wire outlet notch is formed at the main body. In a direction from the main body to the cover, the wire outlet portion protrudes from the main body, and the cover abuts against the wire outlet portion to compress the wire outlet portion to seal the gap between the wire harness assembly and the inner wall of the wire outlet hole.

In some optional embodiments of the present disclosure, the wire harness assembly includes a wire bundling member and an electric control wire harness. The wire bundling member is configured to fix the electric control wire harness and located at the wire outlet hole. The cover abuts against the wire outlet portion to compress the wire outlet portion to seal the gap between the wire bundling member and the inner wall of the wire outlet hole. The wire outlet seal is snap-fitted to the main body.

In some optional embodiments of the present disclosure, the wire harness assembly includes a wire bundling member and an electric control wire harness. The wire bundling member is configured to fix the electric control wire harness. The wire outlet notch has a positioning recess formed at each of two opposite side walls of the wire outlet notch. The wire bundling member includes a wire bundling member body located at the wire outlet hole and a positioning protrusion disposed at each of two opposite sides of the wire bundling member body. The cover abuts against the wire outlet portion to compress the wire outlet portion to seal a gap between the wire bundling member body and the inner wall of the wire outlet hole. The wire outlet hole has an avoidance groove formed at the inner wall of the wire outlet hole. The wire outlet hole is in communication with the positioning recess through the avoidance groove, and the positioning protrusion is received in the avoidance groove and the positioning recess.

In some optional embodiments of the present disclosure, side walls of the wire outlet notch located at two sides of the positioning recess are a first side wall and a second side wall, respectively. The wire outlet portion has a first limit groove and a second limit groove formed on the wire outlet portion, the first side wall is received in the first limit groove, and the second side wall is received in the second limit groove.

In some optional embodiments of the present disclosure, the wire outlet seal includes a plurality of wire outlet portions arranged at intervals in a circumferential direction of the main body. Adjacent wire outlet portions of the plurality of wire outlet portions are connected by a connection rib located outside the main body and in contact with or connected to an outer wall surface of the main body.

In some optional embodiments of the present disclosure, the wire outlet seal includes two wire outlet sub-seals formed independently. The two wire outlet sub-seals together define the wire outlet hole.

According to some optional embodiments of the present disclosure, the wire outlet notch is formed at the main body, and the wire outlet hole extends through a side of the wire outlet portion facing the cover.

In some optional embodiments of the present disclosure, the wire outlet seal has an engagement groove formed thereon and located adjacent to the wire outlet notch, and the cover is provided with an engagement protrusion. The engagement protrusion is in an interference fit with the engagement groove to compress the wire outlet portion.

In some optional embodiments of the present disclosure, the engagement protrusion and the cover are integrally formed; or the engagement protrusion is bonded or snap-fitted to the cover.

In some optional embodiments of the present disclosure, in a direction from the main body to the cover, a width of each of the engagement groove and the engagement protrusion increases.

In some optional embodiments of the present disclosure, the wire outlet hole includes a receiving hole segment and a limit hole segment. The electric control wire harness is adapted to enter and pass through the receiving hole segment via the limit hole segment, and a width of the limit hole segment is smaller than a width of the receiving hole segment in a circumferential direction of the main body.

In some optional embodiments of the present disclosure, the wire outlet hole further includes a guiding hole segment located at a side of the limit hole segment away from the receiving hole segment and extending through the side of the wire outlet portion facing the cover. In a direction from the limit hole segment to the guiding hole segment, a width of the guiding hole segment in the circumferential direction of the main body gradually increases.

In some optional embodiments of the present disclosure, the wire outlet hole includes a first wire passing hole group and a second wire passing hole that are connected sequentially. The first wire passing hole group includes a plurality of first wire passing holes, and the second wire passing hole is in communication with each of the plurality of first wire passing holes. The wire harness assembly includes a plurality of electric control wire harnesses sequentially passing through the plurality of first wire passing holes and the second wire passing hole.

In some optional embodiments of the present disclosure, the at least one of the main body and the cover has a wire outlet notch, and the wire outlet seal includes: a first wire passing sleeve configured to at least partially pass through the wire outlet notch, the first wire passing sleeve having the plurality of first wire passing holes; and a second wire passing sleeve connected to an axial end of the first wire passing sleeve and having the second wire passing hole. A diameter of the second wire passing sleeve is smaller than a diameter of the first wire passing sleeve.

In some optional embodiments of the present disclosure, the first wire passing sleeve is at least partially in an interference fit with the wire outlet notch.

In some optional embodiments of the present disclosure, two second wire passing sleeves are provided. The two second wire passing sleeves are disposed at two ends of the first wire passing sleeve in an axial direction of the first wire passing sleeve, respectively.

In some optional embodiments of the present disclosure, the plurality of first wire passing holes are arranged at intervals in a circumferential direction of the first wire passing sleeve.

In some optional embodiments of the present disclosure, a diameter of the second wire passing hole is smaller than a diameter of a circumscribed circle of the plurality of first wire passing holes.

In some optional embodiments of the present disclosure, an axial direction of the first wire passing hole is parallel to an axial direction of the wire outlet notch; and/or an axial direction of the second wire passing hole is parallel to the axial direction of the wire outlet notch.

According to some embodiments of the present disclosure, the cover is connected to the main body by a fastener or through welding.

An outdoor unit according to an embodiment of a second aspect of the present disclosure includes: an outdoor unit casing; an outdoor heat exchanger disposed in the outdoor unit casing; an outdoor fan disposed in the outdoor unit casing; a compressor assembly disposed in the outdoor unit casing; and the electric control box according to the above embodiments of the first aspect of the present disclosure. The electric control box is disposed in the outdoor unit casing.

With the outdoor unit according to the embodiment of the present disclosure, through the arrangement of the electric control box as described above, by providing the elastic wire outlet seal on the electric control box and forming the wire outlet hole in the wire outlet seal, the wire outlet seal is compressed utilizing the acting force from the mutual engagement between the main body and the cover. Under the compression, the wire outlet seal may undergo the elastic deformation, which can reduce the gap between the wire harness assembly and the inner wall of the wire outlet hole, allow the wire harness assembly to be in an interference fit with the wire outlet hole, and improve the sealing performance between the wire harness assembly and the inner wall of the wire outlet hole. In this way, the sealing performance of the electric control box is improved, and the dust, liquids, or the like, and even the leaked refrigerant can be prevented from entering the electric control box through the gap, which can reduce the safety hazards.

According to some embodiments of the present disclosure, a flammable refrigerant is used as a refrigerant in the outdoor unit.

A heating and ventilation device according to an embodiment of a third aspect of the present disclosure includes the outdoor unit according to the above embodiments of the second aspect of the present disclosure.

With the heating and ventilation according to the embodiment of the present disclosure, through the arrangement of the outdoor unit as described above, by providing the elastic wire outlet seal on the electric control box and forming the wire outlet hole in the wire outlet seal, the wire outlet seal is compressed utilizing the acting force from the mutual engagement between the main body and the cover. Under the compression, the wire outlet seal may undergo the elastic deformation, which can reduce the gap between the wire harness assembly and the inner wall of the wire outlet hole, allow the wire harness assembly to be in an interference fit with the wire outlet hole, and improve the sealing performance between the wire harness assembly and the inner wall of the wire outlet hole. In this way, the sealing performance of the electric control box is improved, and the dust, liquids, or the like, and even the leaked refrigerant can be prevented from entering the electric control box through the gap, which can reduce the safety hazards.

Additional aspects and advantages of the present disclosure will be provided in part in the following description, or will become apparent in part from the following description, or can be learned from practicing of the present disclosure.

### BRIEF DESCRIPTION OF THE DRAWINGS

The above and/or additional aspects and advantages of the present disclosure will become more apparent and more understandable from the following description of embodiments taken in conjunction with the accompanying drawings, in which:
FIG. 1 is a schematic structural view of an electric control box according to a first embodiment of the present disclosure;
FIG. 2 is a schematic view of engagement between a main body and a wire outlet seal in FIG. 1;
FIG. 3 is a schematic view of engagement between a main body and a wire bundling member in FIG. 1;
FIG. 4 is a schematic view of the main body and the wire bundling member in FIG. 3 from another perspective;
FIG. 5 is an enlarged view of part A in FIG. 4;
FIG. 6 is a perspective view of the wire outlet seal in FIG. 2;
FIG. 7 is a perspective view of a first wire outlet sub-seal in FIG. 6;
FIG. 8 is a perspective view of a second wire outlet sub-seal in FIG. 6;
FIG. 9 is a schematic structural view of an electric control box according to a second embodiment of the present disclosure;
FIG. 10 is an enlarged view of part B in FIG. 9;
FIG. 11 is a schematic structural view of a main body in FIG. 9;
FIG. 12 is a schematic structural view of a cover in FIG. 9;
FIG. 13 is a schematic structural view of an electric control box according to a third embodiment of the present disclosure;
FIG. 14 is a schematic view of engagement between a main body and a wire outlet seal in FIG. 13;
FIG. 15 is a schematic structural view of an electric control box according to a fourth embodiment of the present disclosure;
FIG. 16 is a schematic structural view of an electric control box according to a fifth embodiment of the present disclosure;
FIG. 17 is a front view of the electric control box in FIG. 16;
FIG. 18 is a schematic partial structural view of the electric control box in FIG. 16;
FIG. 19 is a schematic structural view of a main body of the electric control box in FIG. 16;
FIG. 20 is a schematic structural view of a wire outlet seal of the electric control box in FIG. 16; and
FIG. 21 is a schematic view of an internal structure of the wire outlet seal in FIG. 20.

Reference numerals:
100, electric control box;
1, electric control box body; 11, cover; 111, engagement protrusion; 12, main body; 120, wire outlet notch; 121, first side wall; 122, second side wall; 123, positioning recess; 13, receiving cavity;
2, wire outlet seal; 20, wire outlet sub-seal; 21, first wire outlet sub-seal; 211, first wire outlet groove; 22, second wire outlet sub-seal; 221, second wire outlet groove; 23, wire outlet portion; 24, wire outlet hole; 241, guiding hole segment; 242, receiving hole segment; 243, limit hole segment; 244, first wire passing sleeve; 245, first wire passing hole; 246, second wire passing sleeve; 247, second wire passing hole; 25, avoidance groove; 26, first limit groove; 27, second limit groove; 28, connection rib; 29, engagement groove;
3, wire harness assembly; 30, wire bundling member; 31, wire bundling member body; 32, positioning protrusion; 33, wire routing hole; 34, electric control wire harness.

### DETAILED DESCRIPTION

The embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limiting, the present disclosure.

An electric control box 100 according to the embodiments of the present disclosure is described below with reference to the accompanying drawings.

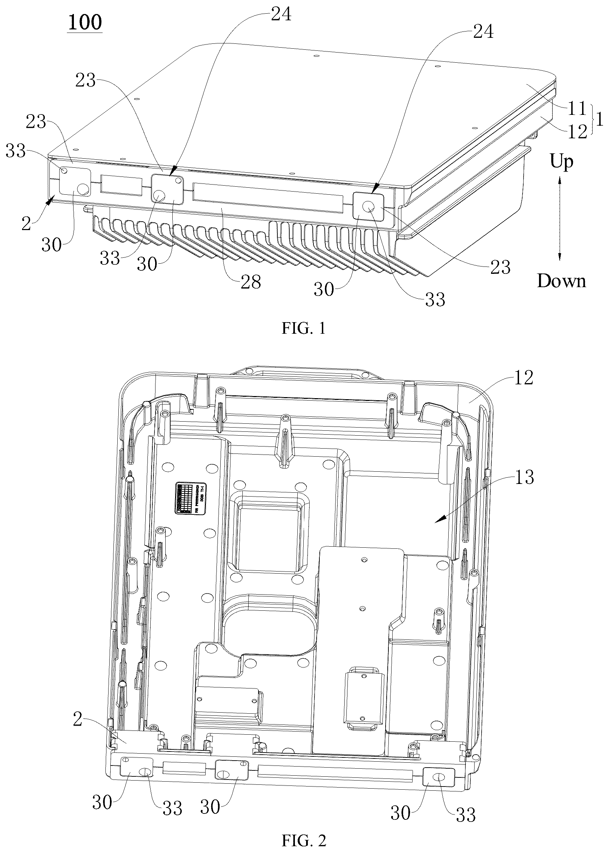

Referring to FIG. 1, FIG. 9, FIG. 13, and FIG. 15, an electric control box 100 according to an embodiment of a first aspect of the present disclosure includes an electric control box body 1, an electric control assembly, and a wire outlet seal 2. The electric control box body 1 includes a main body 12 and a cover 11 connected to the main body 2. Each of the main body 12 and the cover 11 is an independently formed part. The electric control assembly is disposed in the electric control box body 1. For example, the main body 12 has a receiving cavity 13, and the electric control assembly may be disposed in the receiving cavity 13 of the main body 12.

The wire outlet seal 2 is disposed on at least one of the main body 12 and the cover 11. For example, the wire outlet seal 2 may be disposed on the main body 12; or the wire outlet seal 2 may be disposed on the cover 11; or the wire outlet seal 2 may be disposed on both the main body 12 and the cover 11.

According to some embodiments of the present disclosure, the wire outlet seal 2 is integrally formed on the cover 11 or the main body 12; or the wire outlet seal 2 is bonded to the at least one of the main body 12 and the cover 11; or the wire outlet seal 2 is detachably connected to the at least one of the main body 12 and the cover 11.

The wire outlet seal 2 being integrally formed on the cover 11 or the main body 12 can be understood as the wire outlet seal 2 being integrally formed with the cover 11, which can ensure stability of a structure and performance between the wire outlet seal 2 and the cover 11. Alternatively, the wire outlet seal 2 being integrally formed on the cover 11 or the main body 12 can be understood as the wire outlet seal 2 being integrally formed with the main body 12, which can ensure stability of a structure and performance between the wire outlet seal 2 and the main body 12. By integrally forming the wire outlet seal 2 on the cover 11 or the main body 12, not only can stability of a structure and performance between the wire outlet seal 2 and the electric control box 100 be ensured, but also assembly par and connection processes between the wire outlet seal 2 and the electric control box 100 can be reduced, to improve assembly efficiency.

The wire outlet seal 2 is bonded to the at least one of the main body 12 and the cover 11, which can be understood that the wire outlet seal 2 is bonded to the cover 11 or the main body 12 or both the main body 12 and the cover 11. The wire outlet seal 2 is bonded to the at least one of the main body 12 and the cover 11, which can improve the stability of the connection between the wire outlet seal 2 and the electric control box 100.

The wire outlet seal 2 is detachably connected to the at least one of the main body 12 and the cover 11, which can be understood that the wire outlet seal 2 is detachably connected to the main body 12 or the cover 11 or both the cover 11 and the main body. Since the wire outlet seal 2 is detachably connected to the at least one of the main body 12 and the cover 11, during long-term use of the wire outlet seal 2, when the wire outlet seal 2 is damaged and its sealing performance is reduced, the seal may be conveniently disassembled and replaced. For example, the wire outlet seal 2 may be snap-fitted to the main body 12 and the cover 11 or be connected to the main body 12 and the cover 11 by a fastener.

Referring to FIG. 1, FIG. 9, FIG. 13, and FIG. 15, the wire outlet seal 2 has a wire outlet hole 24 and is an elastomer. The wire outlet seal 2 has an elastic deformation capability. The wire harness assembly 3 is electrically connected to the electric control assembly in the electric control box 100 and is adapted to pass through the wire outlet hole 24. The wire outlet seal 2 is compressed through mutual engagement between the main body 12 and the cover 11, and may undergo elastic deformation under the compression, to reduce a gap between the wire harness assembly 3 and an inner wall of the wire outlet hole 24, making the wire harness assembly 3 be in interference fit with the wire outlet hole 24, which can improve sealing performance between the wire harness assembly 3 and the inner wall of the wire outlet hole 24. In this way, sealing performance of the electric control box 100 is further improved, and dust, condensed water, or the like, and even a leaked refrigerant can be prevented from entering the electric control box 100 through the gap, which can reduce safety hazards.

The above-mentioned refrigerant may be a flammable refrigerant, such as R290. The wire outlet seal 2 is compressed to reduce the gap between the wire harness assembly 3 and the inner wall of the wire outlet hole 24, to improve the sealing performance of the electric control box 100, and a risk of explosion caused by the leakage of the flammable refrigerant into the electric control box 100 can be reduced.

With the electric control box 100 according to the embodiments of the present disclosure, by providing an elastic wire outlet seal 2 and forming the wire outlet hole 24 in the wire outlet seal 2, the wire outlet seal 2 is compressed utilizing an acting force from the mutual engagement between the main body 12 and the cover 11. Under the compression, the wire outlet seal 2 may undergo elastic deformation, which can reduce the gap between the wire harness assembly 3 and the inner wall of the wire outlet hole 24, allow the wire harness assembly 3 to be in an interference fit with the wire outlet hole 24, and improve the sealing performance between the wire harness assembly 3 and the inner wall of the wire outlet hole 24. In this way, the sealing performance of the electric control box 100 is improved, and the dust, liquids, or the like, and even the leaked refrigerant can be prevented from entering the electric control box 100 through the gap, which can reduce the safety hazards.

According to some optional embodiments of the present disclosure, the wire outlet seal 2 is a rubber part, allowing the wire outlet seal 2 to have the elastic deformation capability. When the main body 12 and the cover 11 are engaged with each other to compress the wire outlet seal 2, the wire outlet seal 2 may have predetermined elastic deformation, and the inner wall of the wire outlet hole 24 and the wire harness assembly 3 compress against each other. In this way, the gap between the wire harness assembly 3 and the inner wall of the wire outlet hole 24 is reduced, and the sealing performance of the electric control box 100 is improved. Moreover, the rubber part has a good insulation effect and a low cost.

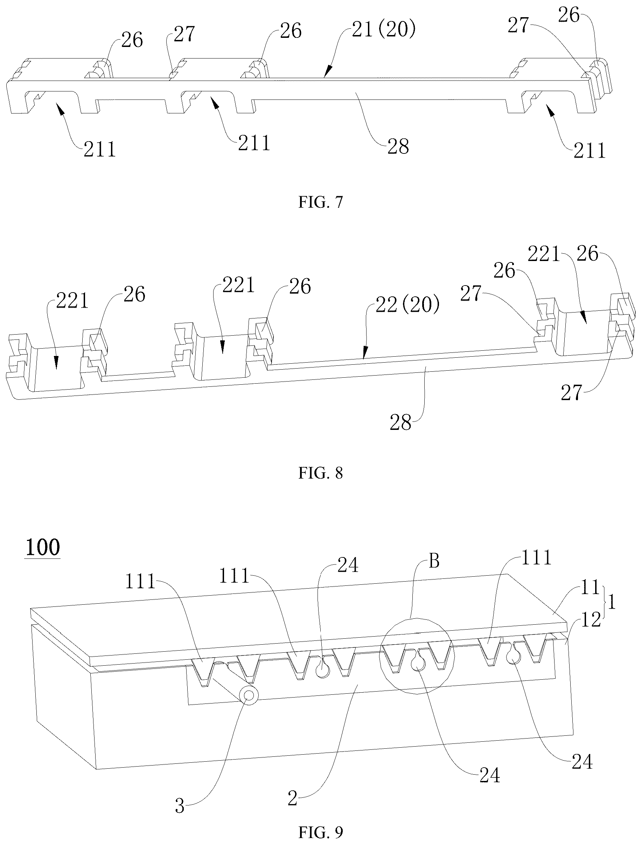

Referring to FIG. 2 and FIG. 9, according to some embodiments of the present disclosure, the wire harness assembly 3 includes a wire bundling member 30 and an electric control wire harness. For example, the wire bundling member 30 may be a plastic part. The wire bundling member 30 is configured to fix the electric control wire harness and located at the wire outlet hole 24. The wire outlet seal 2 is compressed through the mutual engagement between the main body 12 and the cover 11. The wire outlet seal 2 undergoes the elastic deformation under the compressing to seal a gap between the wire bundling member 30 and the inner wall of the wire outlet hole 24, making the wire bundling member 30 be in interference fit with the wire outlet hole 24, which is beneficial to the realization of sealing between the wire harness assembly 3 and the wire outlet hole 24, improving the sealing performance of the electric control box 100.

According to some optional embodiments of the present disclosure, the wire bundling member 30 is integrally injection-molded with the electric control wire harness, which avoids the formation of the gap between the electric control wire harness and the wire bundling member 30, making the sealing performance between the electric control wire harness and the wire bundling member 30 better, and further enhancing the sealing performance of the electric control box 100. In addition, it is possible to reduce assembly processes between the electric control wire harness and the wire bundling member 30, improve the assembly efficiency, and improve the stability between the wire bundling member 30 and the electric control wire harness to prevent the electric control wire harness from shaking inside the wire bundling member 30.

Referring to FIG. 9, according to some optional embodiments of the present disclosure, at least one wire harness assembly 3 is provided, and the electric control wire harness of the at least one wire harness assembly 3 includes a plurality of wire bodies. For example, there may be one wire harness assembly 3, and the electric control wire harness of the one wire harness assembly 3 includes a plurality of wire bodies. Alternatively, there may be a plurality of wire harness assemblies 3, and an electric control wire harness of one of the plurality of wire harness assemblies 3 includes a plurality of wire bodies. Alternatively, there may be a plurality of wire harness assemblies 3, and an electric control wire harness of the plurality of (such as two) wire harness assemblies 3 includes a plurality of wire bodies. By combining the plurality of wire bodies into one electric control wire harness, wire body arrangement is facilitated, which can improve wiring efficiency.

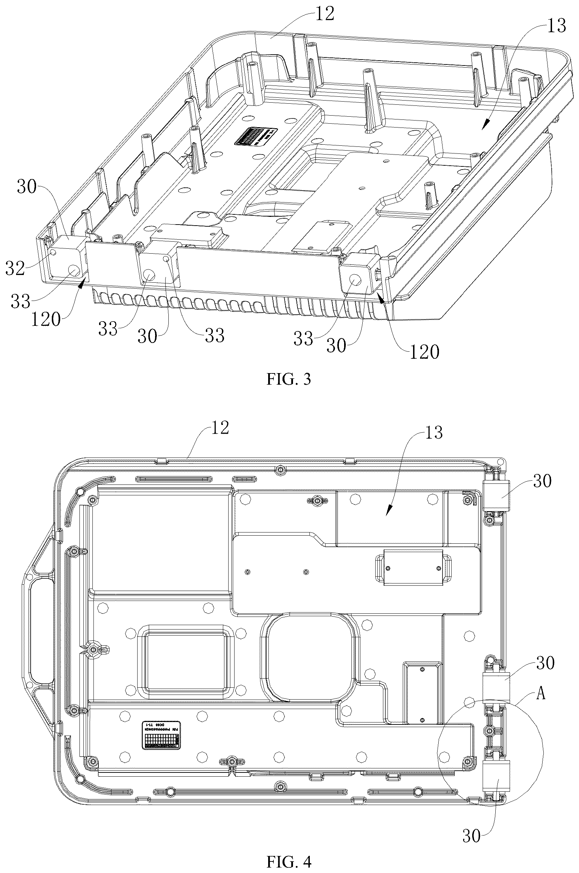

Referring to FIG. 1 to FIG. 3, according to some optional embodiments of the present disclosure, at least one wire harness assembly 3 is provided. The at least one wire harness assembly 3 includes two separately routed electric control wire harnesses. The two separately routed electric control wire harnesses are connected to components with different powers. For example, there may be one wire harness assembly 3, and the wire harness assembly 3 includes two separately routed electric control wire harnesses. Alternatively, there may be a plurality of wire harness assemblies 3, and one of the plurality of wire harness assemblies 3 includes two separately routed electric control wire harnesses. Alternatively, there may be a plurality of wire harness assemblies 3, and the plurality of (such as two) wire harness assemblies 3 includes two separately routed electric control wire harnesses.

The two electric control wire harnesses connected to components with different powers are routed separately, which can prevent an electric control wire harness connected to a high-power component from affecting an electric control wire harness connected to a low-power component, ensuring normal operation of the component, and reducing the safety hazards.

Referring to FIG. 2 to FIG. 3 and FIG. 13 to FIG. 15, according to some embodiments of the present disclosure, the at least one of the main body 12 and the cover 11 has a wire outlet notch 120, and the wire outlet seal 2 includes a wire outlet portion 23, the wire outlet hole 24 is formed on the wire outlet portion 23. The wire outlet portion 23 is at least partially located at the wire outlet notch 120. For example, the main body 12 has a wire outlet notch 120, and the wire outlet portion 23 is partially or completely received in the wire outlet notch 120. For another example, the cover 11 has a wire outlet notch 120, and the wire outlet portion 23 is partially or completely received in the wire outlet notch 120. For another example, each of the cover 11 and the main body 12 has a wire outlet notch 120, and the wire outlet portion 23 is partially or completely received in the wire outlet notches 120 on the cover 11 and the main body 12.

By locating the wire outlet portion 23 of the wire outlet seal 2 at least partially at the wire outlet notch 120, the wire outlet portion 23 may be compressed during the mutual engagement between the main body 12 and the cover 11, which can seal the gap between the inner wall of the wire outlet hole 24 and the wire harness assembly 3, and reduce a gap between a side wall of the wire outlet notch 120 and the wire outlet portion 23, improving the sealing performance of the electric control box 100.

Referring to FIG. 2 and FIG. 13 to FIG. 15, according to some optional embodiments of the present disclosure, the wire outlet notch 120 is formed at the main body 12. For example, the main body 12 has a receiving cavity 13, and the wire outlet notch 120 may be formed at a side wall of the receiving cavity 13 and may extend through the side wall of the receiving cavity 13. In a direction from the main body 12 to the cover 11, the wire outlet portion 23 protrudes from the main body 12, and the cover 11 abuts against the wire outlet portion 23 to compress the wire outlet portion 23 to seal the gap between the wire harness assembly 3 and the inner wall of the wire outlet hole 24, allowing the wire harness assembly 3 to be in an interference fit with the wire outlet hole 24, which can improve the sealing performance of the electric control box 100. Moreover, the wire outlet portion 23 may deform to compress the wire outlet hole 24, to limit the wire harness assembly 3. In addition, the wire outlet portion 23 is compressed by the cover 11, which can also reduce the gap between the wire outlet portion 23 and the side wall of the wire outlet notch 120, further improving the sealing performance of the electric control box 100.

In some optional embodiments of the present disclosure, the wire harness assembly 3 includes a wire bundling member 30 and an electric control wire harness, and the wire bundling member 30 is configured to fix the electric control wire harness. For example, referring to FIG. 1 to FIG. 3, when the wire harness assembly 3 includes one electric control wire harness, the wire bundling member 30 has one wire routing hole 33, and the electric control wire harness is routed through the wire routing hole 33. When the wire harness assembly 3 includes a plurality of electric control wire harness, the wire bundling member 30 has a plurality of wire routing hole 33, and different electric control wire harnesses are routed through different wire routing holes 33, allowing different electric control wire harnesses to be routed separately.

Referring to FIG. 1, the wire bundling member 30 is located at the wire outlet hole 24, and the cover 11 abuts against the wire outlet portion 23 to compress the wire outlet portion 23. The wire outlet portion 23 may undergo elastic deformation under the compression action of the cover 11, to reduce the gap between the wire bundling member 30 and the inner wall of the wire outlet hole 24, allowing the wire bundling member 30 to be in an interference fit with the wire outlet hole 24, to improve the sealing performance between the wire bundling member 30 and the inner wall of the wire outlet hole 24, improving the sealing performance between the wire harness assembly 3 and the inner wall of the wire outlet hole 24.

Referring to FIG. 2 to FIG. 5, the wire bundling member 30 is snap-fitted to the main body 12, which can improve the stability of the connection between the wire harness assembly 3 and the main body 12, preventing the wire harness assembly 3 from being easily disengaged from the main body 12 under the action of an external force. The wire outlet seal 2 is snap-fitted to the main body 12, which can improve the stability of the connection between the wire outlet seal 2 and the main body 12, preventing the wire outlet seal 2 from being easily disengaged from the main body 12 under the action of the external force. In addition, when wire outlet sealing performance of the wire harness assembly 3 and the wire outlet seal 2 deteriorates during long-term use of the wire harness assembly 3 and the wire outlet seal 2, through the snap-fit connection between the wire bundling member 30 and the main body 12 and the snap-fit connection between the wire outlet seal 2 and the main body 12, it can be convenient to disassembly of the wire harness assembly 3 and the wire outlet seal 2 from the main body 12 for maintenance or replacement.

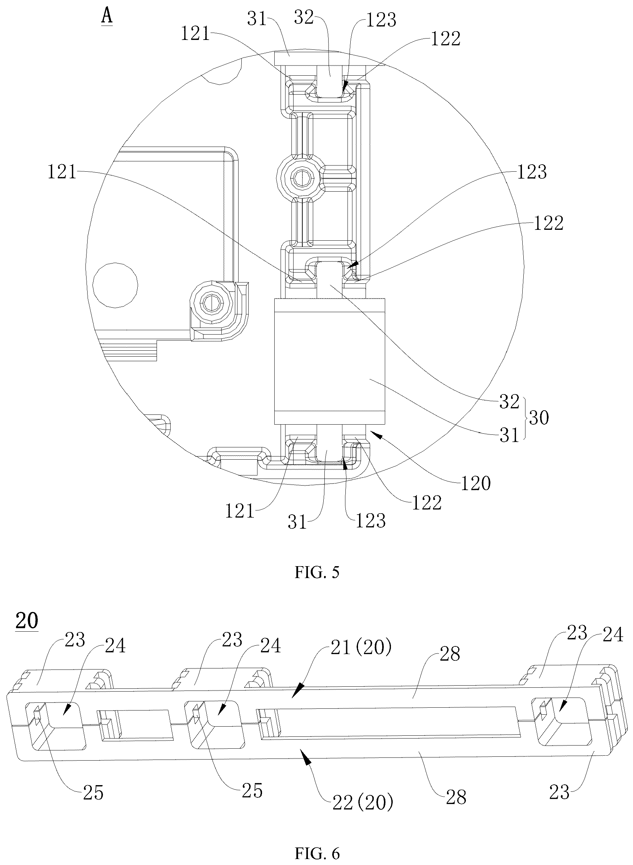

Referring to FIG. 5, in some optional embodiments of the present disclosure, the wire outlet notch 120 has a positioning recess 123 formed at each of two opposite side walls of the wire outlet notch 120, the wire bundling member 30 includes a wire bundling member body 31 located at the wire outlet hole 24 and a positioning protrusion 32 disposed at each of two opposite sides of the wire bundling member body 31. The cover 11 abuts against the wire outlet portion 23 to compress the wire outlet portion 23, to reduce the gap between the wire bundling member body 31 and the inner wall of the wire outlet hole 24, allowing the wire bundling member body 31 to be in an interference fit with the wire outlet hole 24, to improve the sealing performance between the wire bundling member body 31 and the inner wall of the wire outlet hole 24, which is beneficial to the improvement of the sealing performance of the electric control box 100.

Referring to FIG. 6, the wire outlet hole 24 has an avoidance groove 25 formed at the inner wall of the wire outlet hole 24. The wire outlet hole 24 is in communication with the positioning recess 123 through the avoidance groove 25, and the positioning protrusion 32 is received in the avoidance groove 25 and the positioning recess 123. The avoidance groove 25 and the positioning recess 123 may limit the positioning protrusion 32, thereby limiting the wire bundling member 30. The wire bundling member 30 is snap-fitted to the wire outlet hole 24 and the wire outlet notch 120, to improve the stability of the wire bundling member 30, improving the stability of the wire harness assembly 3.

Referring to FIG. 5, FIG. 7, and FIG. 8, in some optional embodiments of the present disclosure, side walls of the wire outlet notch 120 located at two sides of the positioning recess 123 are a first side wall 121 and a second side wall 122, respectively. The wire outlet portion 23 has a first limit groove 26 and a second limit groove 27 formed on the wire outlet portion 23. The first limit groove 26 corresponds to the first side wall 121, and the second limit groove 27 corresponds to the second side wall 122. The first side wall 121 is received in the first limit groove 26, and the second side wall 122 is received in the second limit groove 27, which enables the wire outlet portion 23 to be snap-fitted to the side wall of the wire outlet notch 120, realizing the snap-fit connection between the wire outlet seal 2 and the main body 12 and improving mounting stability of the wire outlet seal 2. For example, the first side wall 121 is a part of the side wall of the wire outlet notch 120 that is located on a side of the positioning recess 123 close to the electric control assembly, and the second side wall 122 is a part of the side wall of the outlet notch 120 that is located on a side of the positioning recess 123 away from the electric control assembly.

Referring to FIG. 1 and FIG. 6, in some optional embodiments of the present disclosure, the wire outlet seal 2 includes a plurality of wire outlet portions 23 arranged at intervals in a circumferential direction of the main body 12. The wire outlet hole 24 is formed at the wire outlet portion 23, so a plurality of wire outlet holes 24 are arranged at intervals in the circumferential direction of the main body 12, making routing of the wire harness assembly 3 uniform and facilitating wire management. For example, the electric control box body 1 may have a plurality of wire outlet notches 120 formed thereon and corresponding to the plurality of wire outlet portions 23 in a one-to-one correspondence, and the wire outlet portion 23 may be disposed at the corresponding wire outlet notch 120.

Referring to FIG. 1 and 6, adjacent wire outlet portions 23 of the plurality of wire outlet portions 23 are connected by a connection rib 28 located at an outer wall surface of the main body 12 and in contact with or connected to the outer wall surface of the main body 12, which can improve structural stability of the plurality of wire outlet portions 23, improving overall stability of the wire outlet seal 2. Adjacent wire outlet portions 23 are connected by the connection rib 28, which can prevent different wire outlet portions 23 from being mounted in a wrong position during assembly of the wire outlet seal 2, improving the assembly efficiency.

In some embodiments, the plurality of wire outlet portions 23 and the connection rib 28 may be integrally injection-molded, which can further improve stability and reliability of the connection between the plurality of wire outlet portions 23 and the connection rib 28, and can reduce the assembly process to improve the assembly efficiency.

Referring to FIG. 6, in some optional embodiments of the present disclosure, the wire outlet seal 2 includes two wire outlet sub-seals 20 formed independently, and the two wire outlet sub-seals 20 together define the wire outlet hole 24. When the wire outlet seal 2 is an integrally formed part, the wire harness assembly 3 is difficult to pass through the wire outlet hole 24. Alternatively, the wire outlet hole 24 is made large enough to allow the wire harness assembly 3 to pass through the wire outlet hole 24, and thus sealing performance between the wire harness assembly 3 and the wire outlet hole 24 is difficult to be ensured. By using the two wire outlet sub-seals 20 formed independently to together define the wire outlet hole 24, it is convenient to connect the wire harness assembly 3 with the wire outlet seal 2, making the wire harness assembly 3 easier to pass through the wire outlet hole 24. Moreover, the gap between the wire harness assembly 3 and the inner wall of the wire outlet hole 24 can be reduced to improve the sealing performance between the wire harness assembly 3 and the wire outlet hole 24.

For example, the two wire outlet sub-seals 20 are a first wire outlet sub-seal 21 and a second wire outlet sub-seal 22, respectively. The first wire outlet sub-seal 21 has a first wire outlet groove 211, and the second wire outlet sub-seal 22 has a second wire outlet groove 221. The two wire outlet sub-seals 20 are opposite to each other in an up-down direction, and the first wire outlet sub-seal 21 is located at an upper side of the second wire outlet sub-seal 22. An opening of the first wire outlet groove 211 faces the second wire outlet sub-seal 22, and an opening of the second wire outlet groove 221 faces the first wire outlet sub-seal 21. When the wire outlet seal 2 and the wire harness assembly 3 are assembled, the second wire outlet sub-seal 22 may be snap-fitted to the main body 12, and the second sub-seal is in contact with a bottom wall of the receiving cavity 13. Then, the positioning protrusion 32 of the wire bundling member 30 is inserted into the positioning recess 123, allowing the wire bundling member 30 to be snap-fitted to the main body 12 and to be partially received in the second wire outlet groove 221. Finally, the first wire outlet sub-seal 21 is snap-fitted to the main body 12, and the wire bundling member 30 is partially received in the first wire outlet groove 211. The first wire outlet groove 211 and the second wire outlet groove 221 are opposite to each other in the up-down direction to form the wire outlet hole 24, and the wire harness assembly 3 passes through the wire outlet hole 24.

For example, referring to FIG. 1, the main body 12 and the cover 11 are engaged with each other in the up-down direction, and the cover 11 may be covered at an upper side of the main body 12. When the cover 11 covers the upper side of the main body 12, the cover 11 and the main body 12 together compress the two wire outlet sub-seals 20 located between the cover 11 and the main body 12. The two wire outlet sub-seals 20 may deform under the compression to reduce a gap between the two wire outlet sub-seals 20, improving a sealing effect of the electric control box 100. Moreover, the two wire outlet sub-seals 20 may compress the wire harness assembly 3 in the wire outlet hole 24 to achieve the sealing between the wire harness assembly 3 and the wire outlet hole 24, further improving the sealing effect of the electric control box 100.

Referring to FIG. 9 to FIG. 15, according to some optional embodiments of the present disclosure, the wire outlet notch 120 is formed at the main body 12, and the wire outlet hole 24 extends through a side of the wire outlet portion 23 facing the cover 11, facilitating the compression of the wire harness assembly 3 into the wire outlet hole 24.

Referring to FIG. 9 to FIG. 12, in some optional embodiments of the present disclosure, the wire outlet seal 2 has an engagement groove 29 formed thereon and located adjacent to the wire outlet notch 120, and the cover 11 is provided with an engagement protrusion 111. The engagement protrusion 111 is in an interference fit with the engagement groove 29 to compress the wire outlet portion 23. The wire outlet portion 23 may compress the wire harness assembly 3, allowing the wire outlet portion 23 to be in close contact with the wire harness assembly 3 to improve the sealing performance of the electric control box 100. For example, a hardness of the engagement protrusion 111 may be greater than a hardness of the wire outlet portion 23.

In some optional embodiments of the present disclosure, the engagement protrusion 111 and the cover 11 are integrally formed, which can not only ensure stability of a structure and performance between the engagement protrusion 111 and the cover 11, but can also eliminate an assembly part and connection process used for the connection between the engagement protrusion 111 and the cover 11, and can improve the assembly efficiency. Alternatively, the engagement protrusion 111 is bonded or snap-fitted to the cover 11, which facilitates the molding of the engagement protrusion 111 and the cover 11 and ensures strong connection stability between the engagement protrusion 111 and the cover 11. Alternatively, the engagement protrusion 111 and the cover 11 may also be connected through welding or by a fastener.

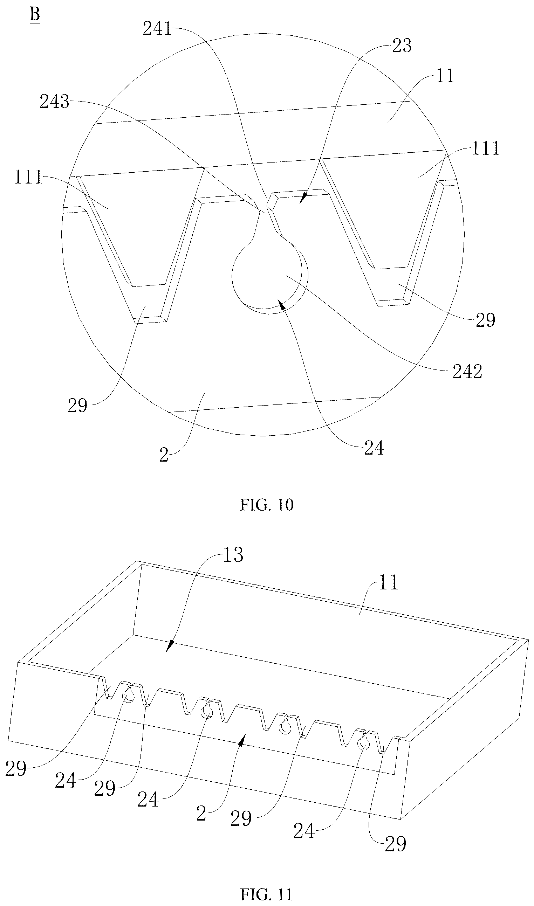

Referring to FIG. 10 to FIG. 12, in some optional embodiments of the present disclosure, in a direction from the main body 12 to the cover 11, a width of each of the engagement groove 29 and the engagement protrusion 111 increases, enabling the main body 12 and the cover 11 to be better engaged with each other. When the cover 11 and the main body 12 are disassembled, it is convenient to disengage the engagement groove 29 from the engagement protrusion 111. In addition, since the width of each of the engagement groove 29 and the engagement protrusion 111 increases in the direction from the main body 12 to the cover 11, when the engagement protrusion 111 is in an interference fit with the engagement groove 29, the wire outlet portion 23 may be compressed in the circumferential direction of the main body 12, and may be also compressed in the direction from the main body 12 to the cover 11, which can better ensure the sealing performance of the electric control box 100.

For example, the engagement groove 29 may be in a trapezoid shape, and the engagement protrusion 111 has the same shape as the engagement groove 29 but with a greater size than the engagement groove 29.

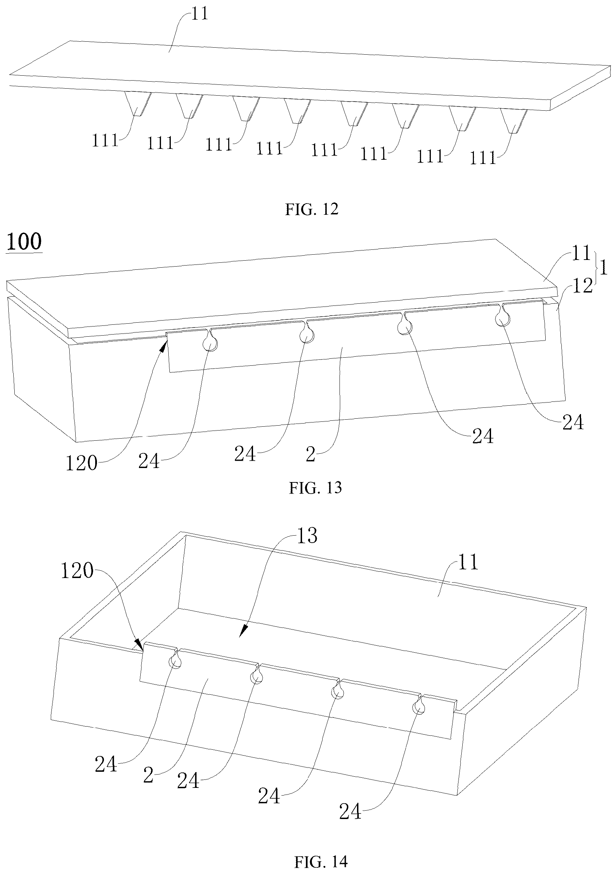

For example, referring to FIG. 13 and FIG. 14, according to other embodiments of the present disclosure, the wire outlet notch 120 is formed at the main body 12, and the wire outlet portion 23 protrudes from the main body 12 in the direction from the main body 12 to the cover 11. The cover 11 is not provided with an engagement protrusion 111, and the wire outlet seal 2 does not have an engagement groove 29. The wire outlet portion 23 is compressed through the mutual engagement between the main body 12 and the cover 11, and deforms to seal the gap between the wire harness assembly 3 and the inner wall of the wire outlet hole 24, improving the sealing performance of the electric control box 100.

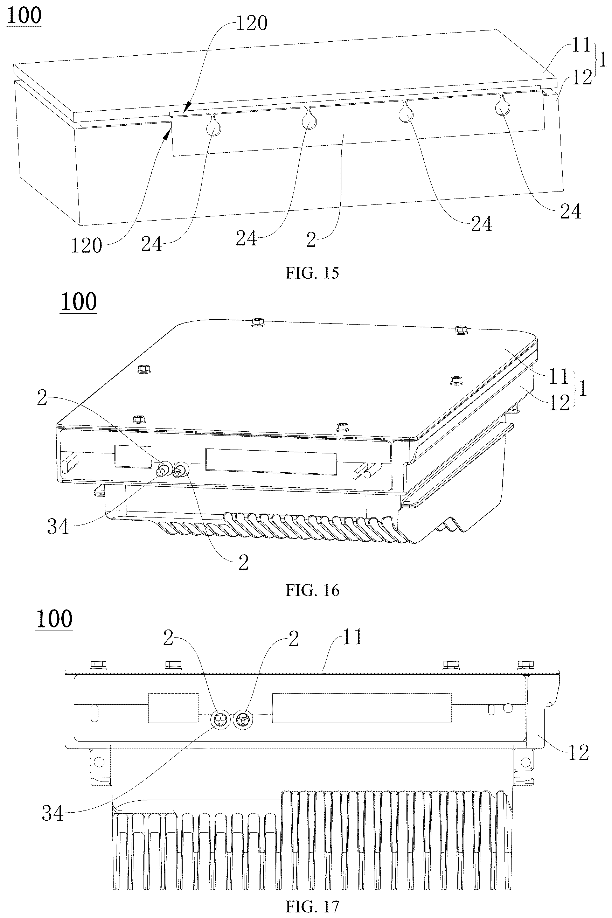

For example, referring to FIG. 15, according to other embodiments of the present disclosure, each of the main body 12 and the cover 11 has a wire outlet notch 120, the wire outlet seal 2 is disposed at the main body 12, and a part of the wire outlet portion 23 of the wire outlet seal 2 is received in the wire outlet notch 120 of the main body 12. In the direction from the main body 12 to the cover 11, other part of the wire outlet portion 23 protrudes from the main body 12, and the part protruding from the main body 12 may be received in the wire outlet notch 120 on the cover 11. The cover 11 is not provided with an engagement protrusion 111, and the wire outlet seal 2 does not have an engagement groove 29.

Referring to FIG. 10, in some optional embodiments of the present disclosure, the wire outlet hole 24 includes a receiving hole segment 242 and a limit hole segment 243. The electric control wire harness is adapted to enter the receiving hole segment 242 via the limit hole segment 243 and pass through the receiving hole segment 242. A width of the limit hole segment 243 is smaller than a width of the receiving hole segment 242 in a circumferential direction of the main body 12. The limit hole segment 243 may limit the electric control wire harness to prevent the electric control wire harness from being easily disengaged from the wire outlet hole 24. For example, the width of the receiving hole segment 242 is smaller than a width of the wire harness assembly 3, and a difference between the width of the receiving hole segment 242 and the width of the wire harness assembly 3 ranges from 2 mm to 3 mm, allowing the receiving hole segment 242 to be in an interference fit with the wire harness assembly 3 and improving sealing performance between the electric control wire harness and the wire outlet hole 24.

Referring to FIG. 10, in some optional embodiments of the present disclosure, the wire outlet hole 24 further includes a guiding hole segment 241 located at a side of the limit hole segment 243 away from the receiving hole segment 242 and extending through the side of the wire outlet portion 23 facing the cover 11. In a direction from the limit hole segment 243 to the guiding hole segment 241, a width of the guiding hole segment 241 in the circumferential direction of the main body 12 gradually increases. The electric control wire harness may be compressed into the receiving hole segment 242 through the guiding hole segment 241 and the limit hole segment 243 in sequence, and the guiding hole segment 241 plays a guiding role in compressing the electric control wire harness into the receiving hole segment 242.

The wire outlet seal 2 is compressed through the mutual engagement between the main body 12 and the cover 11, and the wire outlet portion 23 may deform in the direction from the cover 11 to the main body 12 and also deform in the circumferential direction of the main body 12, which makes two side walls of the guiding hole segment 241 abut with each other, two side walls of the limit hole segment 243 abut with each other, and the receiving hole segment 242 be in interference fit with the wire harness assembly 3, to reduce the gap between the wire harness assembly 3 and the inner wall of the wire outlet hole 24 and improve the sealing performance of the electric control box 100.

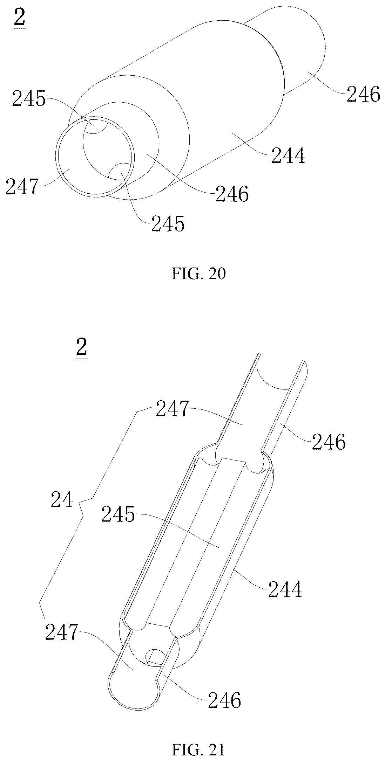

As shown in FIG. 16 to FIG. 21, according to some embodiments of the present disclosure, the wire outlet seal 2 defines a wire outlet hole 24 including a first wire passing hole group and a second wire passing hole 221 that are connected sequentially. The first wire passing hole group includes a plurality of first wire passing holes 211, and the second wire passing hole 221 is in communication with each of the plurality of first wire passing holes 211.

The wire outlet seal 2 may have a cylindrical structure, and the wire outlet seal 2 internally defines the wire outlet hole 24. The receiving cavity 11 is connected to the outside through the wire passing hole. The wire outlet seal 2 may pass through and be received in the wire outlet notch 120 to seal the wire outlet notch 120, making mounting more convenient. The wire outlet hole 24 is formed in an axial direction of the wire outlet notch 120, and includes a first wire passing hole group composed of a plurality of first wire passing holes 211 and a second wire passing hole 221 separately formed. The first wire passing hole 211 is used for the electric control wire harness 34 of the wire harness assembly 3 to pass through. The second wire passing hole 221 may be formed at an axial end of the first wire passing hole 211, or a second wire passing hole 221 may be formed at each of two axial ends of the first wire passing hole 211. The second wire passing hole 221 is configured to fix the wire harness assembly 3 before the wire harness assembly 3 is divided into a plurality of wire harnesses and to gather and fix the wire harness assembly 3 after the wire harness assembly 3 passes through. The plurality of first wire passing holes 211 may be arranged in an array, such as a circular array, along the radial direction of the wire outlet notch 120, to adapt to a wire harness assembly 3 designed as a cylindrical cable structure.

In this embodiment, the wire outlet seal 2 is mounted in the electric control box body 1, the wire outlet seal 2 has a wire outlet hole 24 through which the wire harness assembly 3 in the electric control box body 1 passes. The wire outlet hole 24 has a plurality of first wire passing holes 211. The wire harness assembly 3 may be designed into a multi-wire harness structure similar to a cable at a wire outlet position. Each electric control wire harness 34 is inserted through the corresponding first wire passing hole 211 for fixation and passed out of the electric control box body 1, which further ensures that the wire harness assembly 3 have a small deformation stress at the wire outlet position, and its structure is stable and not easy to bounce, facilitating the mounting of the wire harness assembly 3 at the wire outlet position.

In some embodiments of the present disclosure, referring to FIG. 16 to FIG. 21, the wire outlet seal 2 includes a first wire passing sleeve 21 and a second wire passing sleeve 22. The first wire passing sleeve 21 is at least partially mounted in the wire outlet notch 120 with an interference fit, and has a plurality of first wire passing holes 211. The second wire passing sleeve 22 is connected to an end of the first wire passing sleeve 21 in an axial direction of the first wire passing sleeve 21, and has the second wire passing hole 221. A diameter of the second wire passing sleeve 22 is smaller than a diameter of the first wire passing sleeve 21.

It can be understood that the first wire passing sleeve 21 has a porous structure and defines a plurality of first wire passing holes 211, which allows the plurality of electric control wire harnesses 34 to pass through the plurality of first wire passing holes 211 in a one-to-one correspondence and a hole wall of the first wire passing hole 211 to limit the electric control wire harness 34, improving the connection reliability of the electric control wire harness 34, and allowing the wire harness assembly 3 not to be easily twist and bend in the first wire passing sleeve 21 and to have good structural stability. The first wire passing hole 211 may have a shape adapted to the electric control wire harness 34, such as a circular hole with a diameter close to a diameter of the electric control wire harness 34, which allows a gap between the electric control wire harness 34 and the first wire passing sleeve 21 after the electric control wire harness 34 passes through the first wire passing hole 211 to be relatively small, with good sealing performance. A length of the first wire passing sleeve 21 may be greater than a length of the wire outlet notch 120, allowing the first wire passing sleeve 21 to be partially mounted at the wire outlet notch 120 with an interference fit to achieve the sealing. The plurality of first wire passing holes 211 may be arranged in a circular array or a rectangular array, and an axial direction of the first wire passing hole 211 may be the same as the axial direction of the wire outlet notch 120, making it smoother for the electric control wire harness 34 to pass through. It can be understood that the second wire passing sleeve 22 is a single-hole segment, allowing the plurality of electric control wire harnesses 34 passing through the plurality of first wire passing holes 211 to be gathered at the second wire passing hole 221, facilitating further wiring.

In some embodiments of the present disclosure, the first wire passing sleeve 21 is at least partially in an interference fit with the wire outlet notch 120.

It can be understood that the first wire passing sleeve 21 of the wire outlet seal 2 is mounted at the wire outlet notch 120 of the electric control box 100 with an interference fit, allowing a position between the wire harness assembly 3 of the electric control box 100 and the wire outlet notch 120 to be sealed. The first wire passing sleeve 21 is in an interference fit with the wire outlet notch 120, with a good sealing effect and a low implementation cost, which prevents external dust and liquids from easily entering the interior of the electric control box 100, improving the reliability of the electric control box 100.

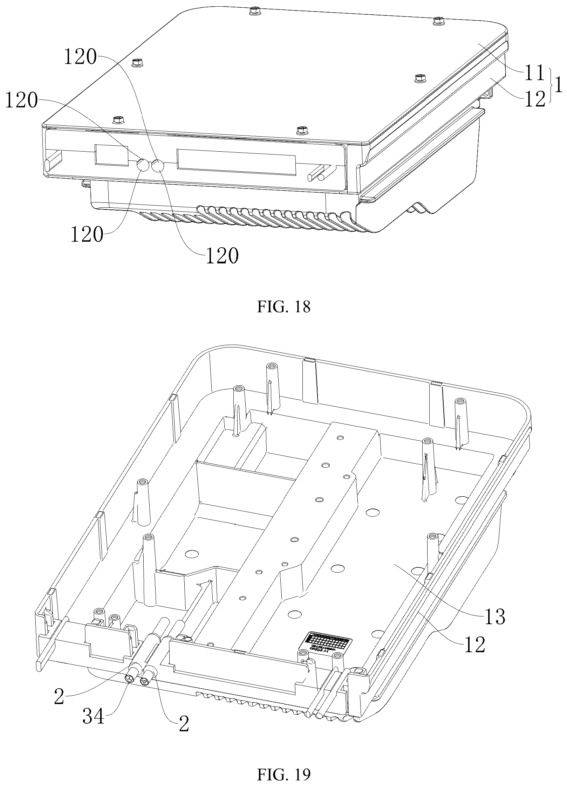

In some embodiments of the present disclosure, referring to FIG. 19 to FIG. 21, two second wire passing sleeves 22 are provided, and a second wire passing sleeve 21 is disposed at each of two ends of the first wire passing sleeve 21 in an axial direction of the first wire passing sleeve 21.

It can be understood that a second wire passing sleeve 22 may be provided at each of the two ends of the first wire passing sleeve 21 in the axial direction of the first wire passing sleeve 21. In this way, the wire harness assembly 3 penetrates the wire outlet seal 2 from the second wire passing sleeve 22 located in the receiving cavity 11, then is dispersed into the plurality of first wire passing holes 211 for fixation, and finally is gathered into the other second wire passing sleeve 22 located outside the electric control box body 1 to be connected to other wires.

In some embodiments of the present disclosure, the plurality of first wire passing holes 211 are distributed in a circular array along a circumferential direction of the first wire passing sleeve 21.

It can be understood that three first wire passing holes 211 may be formed and distributed in a circular array, enabling the wire harness assembly 3 to be designed into a cable-like structure, i.e., a radial cross-section of the wire harness assembly 3 is circular, and the plurality of electric control wire harnesses 34 of the wire harness assembly 3 are arranged in a circular array. In addition, the first wire passing holes 211 are arranged neatly, which facilitates production and routing.

In some embodiments of the present disclosure, a diameter of the second wire passing hole 221 is smaller than a diameter of a circumscribed circle of the plurality of first wire passing holes 211.

It can be understood that after the plurality of first wire passing holes 211 are distributed in a circular array, the diameter of the circumscribed circle of the plurality of first wire passing holes 211 is greater than the diameter of the second wire passing hole 221, which allows the wire harness assembly 3 in the second wire passing hole 221 to be in a gathered posture with respect to the wire harness assembly 3 in the first wire passing hole 211, and the wire harness assembly 3 to have a small deformation stress. After the wire harness assembly 3 is placed, the wire harness assembly 3 has a small deformation and stable posture, making it less likely to bounce and simpler and more convenient to mount.

In some embodiments of the present disclosure, an axial direction of the first wire passing hole 211 and/or an axial direction of the second wire passing hole 221 is parallel to an axial direction of the wire outlet notch 120.

It can be understood that the first wire passing hole 211 and the second wire passing hole 221 may be parallel to the axial direction of the wire outlet notch 120, and the second wire passing sleeve 22 may be coaxially arranged with the first wire passing sleeve 21, making routing smoother. The wire outlet seal 2 is configured to fix and protect the wire harness assembly 3.

In some embodiments of the present disclosure, the first wire passing hole 211 and/or the second wire passing hole 221 is a circular hole.

It can be understood that the first wire passing hole 211 and the second wire passing hole 221 may be adapted to the shape of the electric control wire harness 34. For example, when the electric control wire harness 34 has a cylindrical cable-like structure, the first wire passing hole 211 and the second wire passing hole 221 may be designed to be circular, to adapt to an outer surface of the wire harness 30, improving the reliability of the connection between the wire outlet seal 2 and the electric control wire harness 34, reducing an assembly gap, and improving the sealing performance.

It can be understood that the wire outlet seal 2 may be an integrally formed structure made of rubber or silica gel, and thus has elasticity, which facilitates mounting of the wire outlet seal 2 in the wire outlet notch 120 with an interference fit, to realize firm mounting and have a good sealing effect.

In some embodiments of the present disclosure, the main body 12 has a plurality of wire outlet notches 120, a plurality of wire outlet seals 2 is provided, and a wire outlet seal 2 is mounted at each of the plurality of wire outlet notches 120 with an interference fit.

It can be understood that a plurality of wire outlet notches 120 may be arranged at intervals at the side wall of the main body 12 to allow different wire harness assemblies 3 to pass through. In addition, adjacent wire harness assemblies 3 may be set to have the same diameter, and the same wire outlet seal 2 is used for wire outlet, reducing part differences and achieving a fool-proofing effect.

In some embodiments of the present disclosure, the electric control box 100 includes at least one wire harness assembly 3. The radial cross-section of the wire harness assembly 3 is circular. The wire harness assembly 3 is partially located in the receiving cavity 11. The wire harness assembly 3 includes a plurality of electric control wire harnesses 34 that pass through the first wire passing hole 211 and the second wire passing hole 221 sequentially.

It can be understood that the wire outlet seal 2 allows the wire harness assembly 3 to be configured as a cable-like structure, i.e., a structure with a circular radial cross-section and a plurality of wire harnesses extending in parallel. The electric control wire harness 34 pass through the corresponding first wire passing hole 211, allowing for a reduction in the deformation stress of the wire harness assembly 3 at the wire outlet notch 120, facilitating mounting and routing, and making the wire harness assembly 3 not to easily bounce.

According to some embodiments of the present disclosure, the cover 11 is connected to the main body by a fastener or through welding, which can improve the stability of the connection between the cover 11 and the main body, ensuring the overall stability of the electric control box body 1 and a relatively simple connection method.

The electric control box 100 according to some specific embodiments of the present disclosure will be described below with reference to FIG. 1 to FIG. 15.

### First embodiment

In some embodiments, referring to FIG. 1 to FIG. 8, in this embodiment, the electric control box 100 includes an electric control box body 1, an electric control assembly, and a wire outlet seal 2. The electric control box body 1 includes a main body 12 and a cover 11 connected to the main body 12. Each of the main body 12 and the cover 11 is an independently formed part. The main body 12 and the cover 11 are connected by a fastener, and the electric control assembly is disposed in the electric control box body 1.

The main body 12 has a receiving cavity 13, and a plurality of wire outlet notches 120 are formed at a side wall of the receiving cavity 13 and may extend through the side wall of the receiving cavity 13. In a circumferential direction of the main body 12, each of two opposite side walls of the wire outlet notch 120 has a positioning recess 123. Side walls of the wire outlet notch 120 located at two sides of the positioning recess 123 are a first side wall 121 and a second side wall 122, respectively. The first side wall 121 is a part of the side wall of the wire outlet notch 120 that is located at a side of the positioning recess 123 close to the electric control assembly, and the second side wall 122 is a part of the side wall of the wire outlet notch 120 that is located at a side of the positioning recess 123 away from the electric control assembly.

The wire outlet seal 2 is disposed at the main body 12 and is detachably connected to the main body 12. The wire outlet seal 2 is a rubber part and includes a plurality of wire outlet portions 23 arranged at intervals in the circumferential direction of the main body 12, and the plurality of wire outlet portions 23 correspond to the plurality of wire outlet notches 120 in a one-to-one correspondence. The wire outlet portion 23 may be disposed at the corresponding wire outlet notch 120. Each wire outlet portion 23 has a wire outlet hole 24, and the wire outlet hole 24 has an avoidance groove 25 formed at an inner wall of the wire outlet hole 24. The wire outlet hole 24 is in communication with the positioning recess 123 through the avoidance groove 25. The wire outlet portion 23 has a first limit groove 26 corresponding to the first side wall 121 and a second limit groove 27 corresponding to the second side wall 122. The first side wall 121 is received in the first limit groove 26, and the second side wall 122 is received in the second limit groove 27, enabling the wire outlet portion 23 to be snap-fitted to the side wall of the wire outlet notch 120. Adjacent wire outlet portions 23 are connected by a connection rib 28 located at an outer wall surface of the main body 12 and in contact with the outer wall surface of the main body 12.

The wire outlet seal 2 includes two wire outlet sub-seals 20 formed independently, and the two wire outlet sub-seals 20 are a first wire outlet sub-seal 21 and a second wire outlet sub-seal 22, respectively. The first wire outlet sub-seal 21 has a first wire outlet groove 211, and the second wire outlet sub-seal 22 has a second wire outlet groove 221. The two wire outlet sub-seals 20 are opposite to each other in an up-down direction, and the first wire outlet sub-seal 21 is located at an upper side of the second wire outlet sub-seal 22. An opening of the first wire outlet groove 211 faces the second wire outlet sub-seal 22, and an opening of the second wire outlet groove 221 faces the first wire outlet sub-seal 21. When the first wire outlet sub-seal 21 and the second wire outlet sub-seal 22 are opposite to each other in the up-down direction, the first wire outlet groove 211 and the second wire outlet groove 221 together define the wire outlet hole 24, and the wire harness assembly 3 passes through the wire outlet hole 24.

A plurality of wire harness assemblies 3 is provided. The wire harness assembly 3 includes a wire bundling member 30 and an electric control wire harness, and the electric control wire harness includes a plurality of wire bodies. Two of the plurality of wire harness assemblies 3 include two separately routed electric control wire harnesses, and the two separately routed electric control wire harnesses are connected to components with different powers. The wire bundling member 30 includes a wire bundling member body 31 and a positioning protrusion 32 disposed at each of two opposite sides of the wire bundling member body 31. The wire outlet hole 24 has an avoidance groove 25 formed at the inner wall of the wire outlet hole 24, the wire outlet hole 24 is in communication with the positioning recess 123 through the avoidance groove 25, and the positioning protrusion 32 is received in the avoidance groove 25 and the positioning recess 123. The wire bundling member body 31 is located at the wire outlet hole 24. The cover 11 abuts against the wire outlet portion 23 to compress the wire outlet portion 23, to reduce a gap between the wire bundling member body 31 and the inner wall of the wire outlet hole 24, making the wire bundling member body 31 be in an interference fit with the wire outlet hole 24. The wire bundling member body 31 has a wire routing hole 33, the electric control wire harness pass through the wire routing hole 33, and the wire bundling member body 31 is integrally injection-molded with the electric control wire harness.

When the wire outlet seal 2 and the wire harness assembly 3 are assembled, the second wire outlet sub-seal 22 is snap-fitted to the main body 12, and the second sub-seal is in contact with a bottom wall of the receiving cavity 13. Then, the positioning protrusion 32 of the wire bundling member 30 is inserted into the positioning recess 123, allowing the wire bundling member 30 to be snap-fitted to the main body 12, and the wire bundling member 30 is partially received in the second wire outlet groove 221. Finally, the first wire outlet sub-seal 21 is snap-fitted to the main body 12, and the wire bundling member 30 is partially received in the first wire outlet groove 211. The first wire outlet groove 211 and the second wire outlet groove 221 are opposite to each other in the up-down direction and form the wire outlet hole 24, and the wire harness assembly 3 passes through the wire outlet hole 24.

The wire outlet seal 2 is compressed through the mutual engagement between the main body 12 and the cover 11, and may undergo elastic deformation under the compression to seal a gap between the wire harness assembly 3 and the inner wall of the wire outlet hole 24, allowing the wire harness assembly 3 to be in an interference fit with the wire outlet hole 24.

### Second embodiment

Referring to FIG. 9 to FIG. 12, this embodiment is substantially the same as the first embodiment in structure, in which the same components are denoted by the same reference numerals, and the differences are only as follows.

A main body 12 has a wire outlet notch 120 formed thereon. The wire outlet seal 2 is an integrally formed part, and a wire outlet hole 24 of the wire outlet seal 2 extends through a side of a wire outlet portion 23 facing a cover 11. The wire outlet seal 2 has an engagement groove 29 formed thereon and located adjacent to the wire outlet notch 120, and the cover 11 is provided with an engagement protrusion 111. The engagement protrusion 111 is in an interference fit with the engagement groove 29 to compress the wire outlet portion 23. In a direction from the main body 12 to the cover 11, a width of each of the engagement groove 29 and the engagement protrusion 111 increases. The engagement groove 29 is trapezoidal, and the engagement protrusion 111 has the same shape as the engagement groove 29 but a greater size and hardness than the engagement groove 29.

The wire outlet hole 24 includes a guiding hole segment 241, a receiving hole segment 242, and a limit hole segment 243. The wire harness assembly 3 is adapted to enter and pass through the receiving hole segment 242 via the limit hole segment 243. In a circumferential direction of the main body 12, a width of the limit hole segment 243 is smaller than a width of the receiving hole segment 242, and the width of the receiving hole segment 242 is smaller than a width of the wire harness assembly 3. The guiding hole segment 241 is located at a side of the limit hole segment 243 away from the receiving hole segment 242, and extends through a side of the wire outlet portion 23 facing the cover 11. In a direction from the limit hole segment 243 to the guiding hole segment 241, a width of the guiding hole segment 241 in the circumferential direction of the main body 12 gradually increases.

The wire outlet hole 24 of the wire outlet seal 2 extends through the side of the wire outlet portion 23 facing the cover 11, facilitating compression of the wire harness assembly 3 into the wire outlet hole 24. Through an interference fit of the engagement protrusion 111 with the engagement groove 29, the wire outlet portion 23 is compressed by the engagement protrusion 111 and deforms in the circumferential direction of the main body 12, which allows two side walls of the guiding hole segment 241 to abut with each other, two side walls of the limit hole segment 243 to abut with each other, and the receiving hole segment 242 to be in an interference fit with the wire harness assembly 3 to seal a gap between the wire harness assembly 3 and an inner wall of the wire outlet hole 24, to improve sealing performance between the wire bundling member 30 and the inner wall of the wire outlet hole 24.

### Third embodiment

Referring to FIG. 13 and FIG. 14, this embodiment is substantially the same as the second embodiment in structure, in which the same components are denoted by the same reference numerals, and the differences are only as follows. In a direction from the main body 12 to the cover 11, a wire outlet portion 23 protrudes from a main body 12, and a cover 11 is not provided with an engagement protrusion 111, nor does a wire outlet seal 2 have an engagement groove 29.

The wire outlet portion 23 is compressed through mutual engagement between the main body 12 and the cover 11, and may deform both in a direction from the cover 11 to the main body 12 and in a circumferential direction of the main body 12, which allows two side walls of the guiding hole segment 241 to abut with each other, two side walls of the limit hole segment 243 to abut with each other, and the receiving hole segment 242 to be in an interference fit with the wire harness assembly 3, to reduce a gap between the wire harness assembly 3 and an inner wall of the wire outlet hole 24, improving sealing performance of an electric control box 100.

### Fourth embodiment

Referring to FIG. 15, this embodiment is substantially the same as the third embodiment in structure, in which the same components are denoted by the same reference numerals, and the differences ore only as follows. Each of a main body 12 and a cover 11 has a wire outlet notch 120, the wire outlet seal 2 is disposed at the main body 12, and a wire outlet portion 23 of the wire outlet seal 2 is partially located at the wire outlet notch 120 of the main body 12. In a direction from the main body 12 to the cover 11, other part of the wire outlet portion 23 protrudes from the main body 12, and the part protruding from the main body 12 may be located at the wire outlet notch 120 on the cover 11.

The wire outlet portion 23 is compressed through mutual engagement between the main body 12 and the cover 11 and may deform both in a direction from the cover 11 to the main body 12 and in a circumferential direction of the main body 12, which allows two side walls of the guiding hole segment 241 to abut with each other, two side walls of the limit hole segment 243 to abut with each other, and the receiving hole segment 242 to be in an interference fit with a wire harness assembly 3, to reduce a gap between the wire harness assembly 3 and an inner wall of the wire outlet hole 24, improving sealing performance of an electric control box 100.

Referring to FIG. 15, an outdoor unit according to an embodiment of a second aspect of the present disclosure includes an outdoor unit casing, an outdoor heat exchanger, an outdoor fan, a compressor assembly, and the electric control box 100 according to the above embodiment of the first aspect of the present disclosure. The outdoor heat exchanger, the outdoor fan, the compressor assembly, and the electric control box 100 as described above are each disposed in the outdoor unit casing, making an overall structure of the outdoor unit compact. For example, the electric control assembly in the electric control box 100 may be electrically connected to the outdoor heat exchanger, the outdoor fan, and the compressor assembly through the wire harness assembly 3, and may control the outdoor heat exchanger, the outdoor fan, and the compressor assembly. For example, the electric control assembly supplies power to the outdoor heat exchanger, the outdoor fan, and the compressor assembly through the wire harness assembly 3.

The refrigerant used in the above outdoor unit is a flammable refrigerant. By enhancing the sealing performance between the wire harness assembly 3 and the inner wall of the wire outlet hole 24, the sealing performance of the electric control box 100 is improved, which can reduce the risk of explosion caused by the leakage of the flammable refrigerant into the electric control box 100.

With the outdoor unit according to the embodiments of the present disclosure, through the arrangement of the electric control box 100 as described above, by providing the elastic wire outlet seal 2 on the electric control box body 1 and forming the wire outlet hole 24 in the wire outlet seal 2, the wire outlet seal 2 is compressed utilizing the acting force from the mutual engagement between the main body 12 and the cover 11. Under the compression, the wire outlet seal 2 may undergo the elastic deformation, which can reduce the gap between the wire harness assembly 3 and the inner wall of the wire outlet hole 24, allow the wire harness assembly 3 to be in an interference fit with the wire outlet hole 24, and improve the sealing performance between the wire harness assembly 3 and the inner wall of the wire outlet hole 24. In this way, the sealing performance of the electric control box 100 is improved, and the dust, liquids, or the like, and even the leaked refrigerant can be prevented from entering the electric control box 100 through the gap, which can reduce the safety hazards.

A heating and ventilation device according to an embodiment of a third aspect of the present disclosure includes the outdoor unit according to the above embodiment of the second aspect of the present disclosure. The heating and ventilation device may be an air conditioning system, a heat pump system, or the like.

With the heating and ventilation according to the embodiments of the present disclosure, through the arrangement of the outdoor unit as described above, by providing the elastic wire outlet seal 2 on the electric control box 1 and forming the wire outlet hole 24 in the wire outlet seal 2, the wire outlet seal 2 is compressed utilizing the acting force from the mutual engagement between the main body 12 and the cover 11. Under the compression, the wire outlet seal 2 may undergo the elastic deformation, which can reduce the gap between the wire harness assembly 3 and the inner wall of the wire outlet hole 24, allow the wire harness assembly 3 to be in an interference fit with the wire outlet hole 24, and improve the sealing performance between the wire harness assembly 3 and the inner wall of the wire outlet hole 24. In this way, the sealing performance of the electric control box 100 is improved, and the dust, liquids, or the like, and even the leaked refrigerant can be prevented from entering the electric control box 100 through the gap, which can reduce the safety hazards.

In the description of the present disclosure, it should be understood that, the orientation or the position indicated by terms such as "center", "longitudinal", "lateral", "length", "width", "thickness", "over", "below", "front", "rear", "left", "right", "vertical", "horizontal", "top", "bottom", "inner", "outer", "clockwise", "anti-clockwise", "axial", "radial", and "circumferential" should be construed to refer to the orientation and the position as shown in the drawings, and is only for the convenience of describing the present disclosure and simplifying the description, rather than indicating or implying that the pointed device or element must have a specific orientation, or be constructed and operated in a specific orientation, and therefore cannot be understood as a limitation of the present disclosure.

In the description of the present disclosure, "plurality" means two or more.

In the description of the present disclosure, the first feature "on" or "under" the second feature may mean that the first feature is in direct contact with the second feature, or the first and second features are in indirect contact through another feature between the first and second features.

In the description of the present disclosure, the first feature "above" the second feature means that the first feature is directly above or obliquely above the second feature, or simply means that the level of the first feature is higher than that of the second feature.

Throughout this specification, description with reference to "an embodiment", "some embodiments", "an illustrative embodiment", "an example", "a specific example", "some examples", or the like means that a particular feature, structure, material, or characteristic described in connection with the embodiment or example is included in at least one embodiment or example of the present disclosure. The appearances of the above phrases in various places throughout this specification are not necessarily referring to the same embodiment or example of the present disclosure. Further, the particular features, structures, materials, or characteristics described here may be combined in any suitable manner in one or more embodiments or examples.

Although embodiments of the present disclosure have been illustrated and described, it is conceivable for those skilled in the art that various changes, modifications, replacements, and variations can be made to these embodiments without departing from the principles and spirit of the present disclosure. The scope of the present disclosure shall be defined by the claims as appended and their equivalents.

## Claims

1. An electric control box, comprising:
an electric control box body comprising a main body and a cover connected to the main body, each of the main body and the cover being an independently formed part;
an electric control assembly disposed in the electric control box body; and
a wire outlet seal disposed on at least one of the main body and the cover, the wire outlet seal having a wire outlet hole and being an elastomer, wherein a wire harness assembly electrically connected to the electric control assembly passes through the wire outlet hole,
wherein the wire outlet seal is compressed through mutual engagement between the main body and the cover to reduce a gap between the wire harness assembly and an inner wall of the wire outlet hole.

2. The electric control box according to claim 1, wherein the wire outlet seal is a rubber part.

3. The electric control box according to claim 1, wherein:
the wire outlet seal is integrally formed on the cover or the main body; or
the wire outlet seal is bonded to the at least one of the main body and the cover; or
the wire outlet seal is detachably connected to the at least one of the main body and the cover.

4. The electric control box according to claim 1, wherein:
the wire harness assembly comprises a wire bundling member and an electric control wire harness, the wire bundling member being configured to fix the electric control wire harness and located at the wire outlet hole; and
the wire outlet seal is compressed through the mutual engagement between the main body and the cover to seal a gap between the wire bundling member and the inner wall of the wire outlet hole.

5. The electric control box according to claim 4, wherein the wire bundling member is integrally injection-molded with the electric control wire harness.

6. The electric control box according to claim 4, wherein at least one wire harness assembly is provided, an electric control wire harness of at least one wire harness assembly comprising a plurality of wire bodies.

7. The electric control box according to claim 4, wherein at least one wire harness assembly is provided, at least one wire harness assembly comprising two separately routed electric control wire harnesses, wherein the two separately routed electric control wire harnesses are connected to components with different powers.

8. The electric control box according to claim 1, wherein:
the at least one of the main body and the cover has a wire outlet notch; and
the wire outlet seal comprises a wire outlet portion, the wire outlet hole being formed on the wire outlet portion, and the wire outlet portion being at least partially located at the wire outlet notch.

9. The electric control box according to claim 8, wherein:
the wire outlet notch is formed at the main body; and
in a direction from the main body to the cover, the wire outlet portion protrudes from the main body, and the cover abuts against the wire outlet portion to compress the wire outlet portion to seal the gap between the wire harness assembly and the inner wall of the wire outlet hole.

10. The electric control box according to claim 9, wherein:
the wire harness assembly comprises a wire bundling member and an electric control wire harness, the wire bundling member being configured to fix the electric control wire harness and located at the wire outlet hole;
the cover abuts against the wire outlet portion to compress the wire outlet portion to seal a gap between the wire bundling member and the inner wall of the wire outlet hole; and
the wire outlet seal is snap-fitted to the main body.

11. The electric control box according to claim 9, wherein:
the wire harness assembly comprises a wire bundling member and an electric control wire harness, the wire bundling member being configured to fix the electric control wire harness;
the wire outlet notch has a positioning recess formed at each of two opposite side walls of the wire outlet notch;
the wire bundling member comprises a wire bundling member body located at the wire outlet hole and a positioning protrusion disposed at each of two opposite sides of the wire bundling member body;
the cover abuts against the wire outlet portion to compress the wire outlet portion to seal a gap between the wire bundling member body and the inner wall of the wire outlet hole; and
the wire outlet hole has an avoidance groove formed at the inner wall of the wire outlet hole, the wire outlet hole being in communication with the positioning recess through the avoidance groove, and the positioning protrusion being received in the avoidance groove and the positioning recess.

12. The electric control box according to claim 11, wherein parts of side walls of the wire outlet notch located at two sides of the positioning recess are a first side wall and a second side wall, respectively, wherein the wire outlet portion has a first limit groove and a second limit groove formed on the wire outlet portion, the first side wall being received in the first limit groove, and the second side wall being received in the second limit groove.

13. The electric control box according to claim 9, wherein the wire outlet seal comprises a plurality of wire outlet portions arranged at intervals in a circumferential direction of the main body, wherein adjacent wire outlet portions of the plurality of wire outlet portions are connected to each other by a connection rib located outside the main body and in contact with or connected to an outer wall surface of the main body.

14. The electric control box according to claim 9, wherein the wire outlet seal comprises two wire outlet sub-seals formed independently, the two wire outlet sub-seals together defining the wire outlet hole.

15. The electric control box according to claim 8, wherein:
the wire outlet notch is formed at the main body; and
the wire outlet hole extends through a side of the wire outlet portion facing the cover.

16. The electric control box according to claim 15, wherein:
the wire outlet seal has an engagement groove formed on the wire outlet seal and located adjacent to the wire outlet notch; and
the cover is provided with an engagement protrusion, the engagement protrusion being in an interference fit with the engagement groove to compress the wire outlet portion.

17. The electric control box according to claim 16, wherein:
the engagement protrusion and the cover are integrally formed; or
the engagement protrusion is bonded or snap-fitted to the cover.

18. The electric control box according to claim 16, wherein in a direction from the main body to the cover, a width of each of the engagement groove and the engagement protrusion increases.

19. The electric control box according to claim 15, wherein the wire outlet hole comprises a receiving hole segment and a limit hole segment, the electric control wire harness being adapted to enter and pass through the receiving hole segment via the limit hole segment, and a width of the limit hole segment being smaller than a width of the receiving hole segment in a circumferential direction of the main body.

20. The electric control box according to claim 19, wherein the wire outlet hole further comprises a guiding hole segment located at a side of the limit hole segment away from the receiving hole segment and extending through the side of the wire outlet portion facing the cover, wherein in a direction from the limit hole segment to the guiding hole segment, a width of the guiding hole segment in the circumferential direction of the main body gradually increases.

21. The electric control box according to claim 1, wherein:
the wire outlet hole comprises a first wire passing hole group and a second wire passing hole that are connected sequentially, the first wire passing hole group comprising a plurality of first wire passing holes, and the second wire passing hole being in communication with each of the plurality of first wire passing holes; and
the wire harness assembly comprises a plurality of electric control wire harnesses sequentially passing through the plurality of first wire passing holes and the second wire passing hole.

22. The electric control box according to claim 21, wherein:
the at least one of the main body and the cover has a wire outlet notch; and
the wire outlet seal comprises:
a first wire passing sleeve configured to at least partially pass through the wire outlet notch, the first wire passing sleeve having the plurality of first wire passing holes; and
a second wire passing sleeve connected to an axial end of the first wire passing sleeve and having the second wire passing hole, a diameter of the second wire passing sleeve being smaller than a diameter of the first wire passing sleeve.

23. The electric control box according to claim 22, wherein the first wire passing sleeve is at least partially in an interference fit with the wire outlet notch.

24. The electric control box according to claim 22, wherein two second wire passing sleeves are provided, the two second wire passing sleeves being disposed at two ends of the first wire passing sleeve in an axial direction of the first wire passing sleeve, respectively.

25. The electric control box according to claim 21, wherein the plurality of first wire passing holes are arranged at intervals in a circumferential direction of the first wire passing sleeve.

26. The electric control box according to claim 25, wherein a diameter of the second wire passing hole is smaller than a diameter of a circumscribed circle of the plurality of first wire passing holes.

27. The electric control box according to claim 21, wherein:
an axial direction of the first wire passing hole is parallel to an axial direction of the wire outlet notch; and/or
an axial direction of the second wire passing hole is parallel to the axial direction of the wire outlet notch.

28. The electric control box according to any one of claims 1 to 27, wherein the cover is connected to the main body by a fastener or through welding.

29. An outdoor unit, comprising:
an outdoor unit casing;
an outdoor heat exchanger disposed in the outdoor unit casing;
an outdoor fan disposed in the outdoor unit casing;
a compressor assembly disposed in the outdoor unit casing; and
the electric control box according to any one of claims 1 to 28, the electric control box being disposed in the outdoor unit casing.

30. The outdoor unit according to claim 29, wherein a flammable refrigerant is used as a refrigerant.

31. A heating and ventilation device, comprising the outdoor unit according to claim 29 or 30.
